# EUROPEAN PATENT APPLICATION

(11) **EP 1 746 669 A2**
(43) Date of publication of application: **24.01.2007**
(21) Application number: 06013965.6
(22) Date of filing: 05.07.2006
(51) Int. Cl.: H01L 51/52

(54) **A thick layer of light emitting polymers to enhance OLED efficiency and lifetime**

(30) Priority: 20.07.2005 US 186201
(71) Applicant: Osram Opto Semiconductors GmbH, 93049 Regensburg (DE)
(72) Inventor: Cumpston, Brian Hylton, Pleasanton CA 94566 (US); So, Franky, San Jose CA 95129 (US); Gupta, Rahul, Milpitas California 95035 (US)
(74) Representative: Epping - Hermann - Fischer

(57) **Abstract**

The light emitting polymer layer "420" of an organic light emitting diode ("OLED") device is formed to be thick having a thickness of more than 80 nanometers and preferably between 80 and 200 nanometers.

## Description

This patent application claims the priority of U.S. patent application 11/186,201, the disclosure content of which is hereby incorporated by reference for all purposes.

### BACKGROUND

An organic light emitting diode ("OLED") device is typically comprised of: (1) a transparent anode on a substrate; (2) a hole injection layer ("HIL"); (3) an electron injection and light emitting layer ("emissive layer"); and (4) a cathode. When a forward bias is applied, holes are injected from the anode into the HIL, and the electrons are injected from the cathode into the emissive layer. Both carriers are then transported towards the opposite electrode and allowed to recombine with each other, the location of which is called the recombination zone. The recombination of holes and electrons in the emissive layer produce excitons which then emit light.

The emissive layer in an OLED typically is composed of one or more organic compounds (such as monomers or polymers) dissolved in a solvent. The organic solution may contain other elements such as wetting agents, cross-linking agents, side-groups and so on. The emissive layer is fabricated by depositing this organic solution onto the HIL or other underlying layer and allowing or causing (by baking or cross-linking) the solution to dry into a film. The organic solution may be deposited using selective deposition techniques such as inkjet printing or non-selective deposition techniques such as spin-coating.

Displays made from OLED pixels may be either passive-matrix or active-matrix. Active-matrix displays are fabricated by including switching elements within each OLED pixel so that they can be individually activated or inactivated. Passive matrix displays have no pixel-internal switching elements and are driven instead by line by line scanning or multiplexing. As a result, passive-matrix displays require a higher voltage to drive them than active matrix or other displays. The high driving voltage increases typically when even more rows of display need to be addressed. This high driving voltage can tend to degrade the performance of the emissive polymer, and especially so over time, leading to lower lifetimes.

One problem with PPV and polyfluorene-based light emitting polymers, and generally any class of polymeric light emitting material, is that they exhibit lifetimes, particularly under multiplexed operation for passive matrix display applications that are too short for many commercially attractive applications. Until now, OLED devices have been fabricated with light emitting polymer (LEP) thicknesses on the order of 70 - 80 nm which provide good photopic efficiency and reasonably low voltage requirements (<10 V). However, with very few exceptions, these device structures do not exhibit the required lifetimes.

Therefore, there is a need to improve OLED device efficiency and lifetime especially for particular applications of OLED displays.

### SUMMARY

An organic light emitting diode ("OLED") device according to at least one aspect of the invention has a plurality of stacked layers, comprising a light emitting polymer layer having a thickness, as measured between two layers adjacent thereto, of eighty nanometers or more, preferably between eighty and two hundred nanometers, where the boundaries are included.

In one embodiment, the OLED device comprises a cathode layer, said cathode layer adjacent to said light emitting polymer layer, and a hole injection layer, said hole injection layer also adjacent to said light emitting polymer layer, said thickness measured between said cathode layer and said hole injection layer.

In one embodiment, the OLED device additionally comprises an anode layer.

In a preferably embodiment, said hole injection layer and said light emitting polymer layer are formed using at least one organic material.

Said light emitting polymer layer is preferably formed using at least one of a selective deposition technique and a non-selective deposition technique, said selective deposition technique especially preferably includes inkjet printing and said non-selective deposition technique especially preferably including spin coating.

In one embodiment, the device is used to create an OLED display, which preferably is passive matrix or active matrix in nature.

In one embodiment, the combined thickness of the light emitting polymer layer and hole injection layer is held fixed, the thickness of the hole injection layer decreasing with an increase in the thickness of the light emitting polymer layer.

An organic light emitting diode ("OLED") device, according to a second aspect of the inventions comprises:
- a substrate;
- a first electrode on said substrate;
- a light emitting polymer layer, said light emitting polymer layer having a p-doped region, an n-doped region and a light emitting region; and
- a second electrode on said light emitting polymer layer.

In one embodiment, said p-doped region acts as a hole injection layer.

In one embodiment, said n-doped region acts as an electron injection layer.

In a preferred embodiment, said light emitting polymer layer includes a dissociable salt.

In an especially preferred embodiment, a bias applied to said light emitting polymer creates said n-doped region and said p-doped region by mobilizing ions in said dissociable salt.

### BRIEF DESCRIPTION OF THE DRAWINGS

FIG. 1(a)-1(b) illustrate device luminance versus current density and photopic efficiency versus current density respectively for different LEP layer thickness for a set of devices.
FIG. 2 illustrates the current density versus voltage curves for a set of devices with different LEP thickness.
FIG. 3 illustrates device lifetime versus LEP thicknesses.
FIG. 4 shows a cross-sectional view of an organic electronic device according at least one embodiment of the invention.
FIG. 5 shows a cross-sectional view of an electro-chemical organic electronic device according at least one embodiment of the invention.

### DETAILED DESCRIPTION

In at least one embodiment of the invention, a "thick" light emitting polymer (LEP) layer is disclosed which has a thickness of more than eighty (80) nanometers and in some embodiments, a thickness of between eighty (80) and two hundred (200) nanometers. OLEDs utilizing thick LEP layers have been shown in experiments to provide better photopic efficiency and increase in lifetime than their thinner counterparts. Some applications of thick LEP include, but are not limited to, low multiplex rate passive matrix displays, low brightness displays, and products that can provide 12 to 20 Volts or more (such as lighting products powered with 110V or 220V AC) over the device lifetime. In other embodiments of the invention, the total thickness of the "organic stack" (typically consisting of the HIL layer and LEP layer) is held fixed by reducing the HIL layer thickness while the LEP layer thickness is increased.

An increase in LEP thickness is typically associated with an increase in required drive voltage. This might be expected to decrease efficiency and lifetime because of the additional stress on the device. To avoid this anticipated decrease in performance, and for the reason that many low voltage applications require thin LEP layers rather than thick LEP layers, it is atypical to use a thick LEP layer. However, as discussed above and demonstrated below, the thick LEP layer actually and unexpectedly increases efficiency and lifetime.

Thick LEP devices may also exhibit the following characteristics:
- Considerable reduction in leakage current. The potential reduction in leakage current stems from the larger path (thicker LEP layer) through which current has to travel. This tends to reduce the possibility that a path for leakage current (due to materials defects) will be present. By providing inherently less leakage current in the LEP layer, the thickness of the HIL layer can be reduced. This material is typically made rather thick (>100 nm) in order to provide good coverage of surface defects. However, it has been demonstrated that longer device lifetimes can be achieved when the thickness of the HIL layer is reduced, for example to 100 nanometers or less.

By increasing the LEP thickness while holding the total organic layer thickness constant, additive improvements in device performance can be achieved.
- Significantly better wetting properties of the LEP, thus reducing the number of pinholes; and
- Significantly different Tg (glass transition temperature) compared with a thin layer, allowing better processing conditions. A higher Tg will enable the LEP layer to be processed (baked) at a higher temperature while still avoiding molecular ordering. Molecular ordering within the LEP layer may lead to increased leakage current as the path for conductivity is better defined in the ordered material.

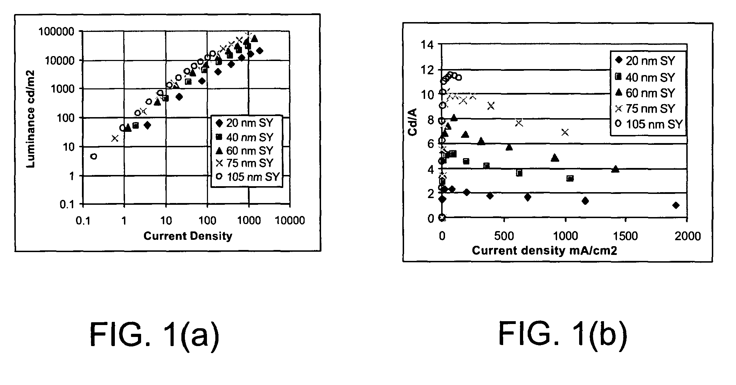

FIG. 1 illustrates device photopic efficiency versus current density for a set of devices with varying LEP layer thickness. Five different thicknesses of LEP layers were utilized in fabricating passive matrix OLED displays, namely thicknesses of 20 nanometers (nm), 40 nm, 60 nm, 75 nm and 105 nm. All other materials and processing conditions with the exception of the noted LEP layer thickness differential were held constant for these OLED devices. Each of the OLED devices tested used for its LEP layer a commercially available Super Yellow (SY) light emtting polymer which is polyvinylenepropylene based. The OLED devices were manufactured using a glass substrate, and Indium Tin Oxide anode layer, a 60 nanometer HIL layer (made of "PEDOT:PSS, see below), an LEP layer of various thickness using SY, and a cathode layer of 3 nanometers Barium and 200 nanometers Aluminum.

In FIG. 1(a), the luminance of each OLED device is plotted against current density for each LEP layer thickness. With an increase in thickness of the LEP layer, the lumiannce was shown to have also increased monotonically. At 105 nm, the best luminance results were observed.

As illustrated in FIG. 1(b), the photopic efficiency (as measured by Cd/A) also increased with increasing LEP layer thickness. This trend indicating an increase in photopic efficiency with increasing LEP layer thickness is due to either more hole-electron recombinations are occurring and/or more of the recombinations are of the emissive type. In particular, it is believed that the "radiative" recombination zone (energy band where recombinations producing light emission occur) is moved away from the interfaces of the LEP layer (see discussion below). Due to a hole/electron injection and/or transport imbalance, recombinations at the interfaces of the LEP layer to other layers may lead to quenching effects which result in non-radiative recombination. As these quenching effects are reduced by movement of the recombination zone, more of the recombinations are radiative in nature. While this cause-effect is not known with certainty, it offers one possible mechanism for explaining the increase in photopic efficiency. The invention, in its various embodiments, can probably be applied to any LEP layer in which an imbalance of charge injection and/or transport may exist.

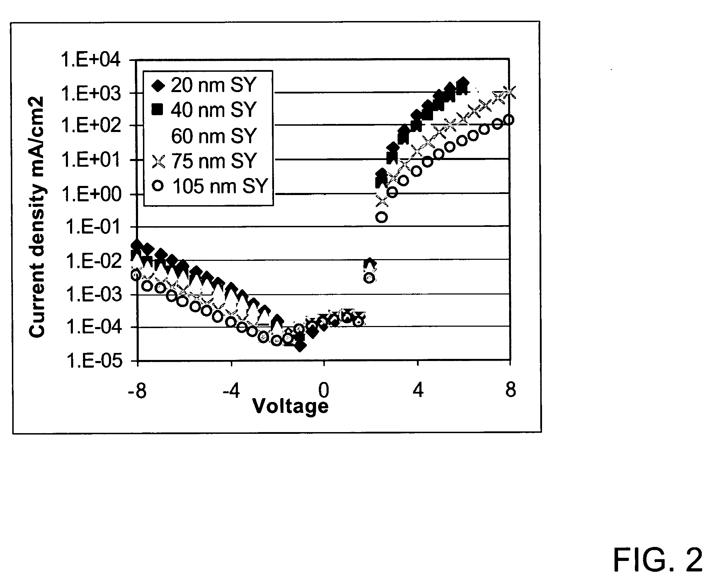

FIG. 2 illustrates the current density versus voltage curves for a set of devices with different LEP thickness. FIG. 2 shows the increased voltage needed to obtain a given current density with increasing thickness of LEP layer. FIG. 2 also illustrates the lower leakage current when negative voltage is applied to the device.

Again, the same five OLED devices tested with respect to FIG. 1(a)-1(b) were used in obtaining the curves of FIG. 2. The forward voltage required to pass a given current through each display also increased with increasing LEP thickness. This would be expected since the resistance through the LEP layer is also presumptively higher with an increasing thickness, and for certain applications would not be detrimental. As mentioned above, it was expected that the increased drive voltage would also lead to a decrease in lifetime and efficiency, however this was demonstrated not to be the case. The apparent effect of correcting the charge imbalance and enabling more efficient recombination of holes and electrons outweighed the negative performance impact of the OLED devices being driven harder.

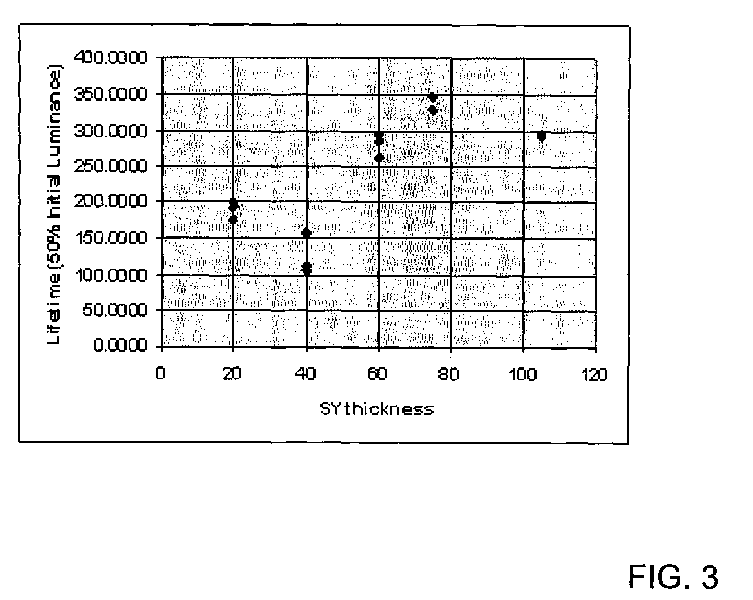

FIG. 3 illustrates device lifetime versus LEP thickness for a set of devices. The luminance of the same set of devices (as utilized in obtaining the results of FIGs 1(a)-(b) and 2) at 50% lifetime was observed. The time required to reach one-half of the initial luminance for the 105 nm LEP based display was around 300 hours while time required to reach one-half of the initial luminance for the 40 nm LEP based device was only around 100-150 hours. This can be viewed as an increase in the effective lifetime of the device.

In other embodiments of the invention, the use of a thick LEP layer would allow the fabrication of electro-chemical OLEDs ("EC-OLEDs") by adding a dissociable salt into the LEP and using non-reactive metal electrodes whose work functions are not critical for the operation of the device. One fraction of the thickness of the LEP thick film would become p-doped at the anode and another fraction would become n-doped at the cathode, the middle fraction would then be the LEP layer. This would be most appropriate for lighting application where switching speed is not critical.

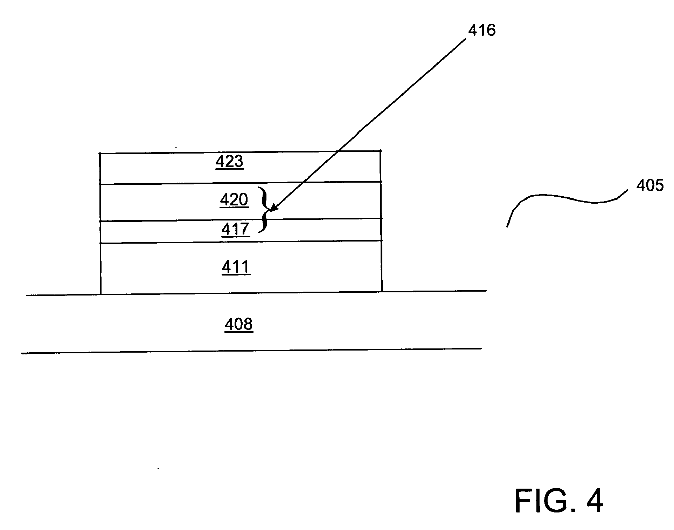

FIG. 4 shows a cross-sectional view of an organic electronic device according at least one embodiment of the invention. The organic electronic device 405 may represent one OLED pixel or sub-pixel of a larger OLED display. As shown in FIG. 4, the organic electronic device 405 includes a first electrode 411 on a substrate 408. As used within the specification and the claims, the term "on" includes when layers are in physical contact and when layers are separated by one or more intervening layers. The first electrode 411 may be patterned for pixilated applications or unpatterned, for example for backlight applications or general lighting. If the electronic device 405 is a transistor, then the first electrode may be, for example, the source and drain contacts of that transistor.

One or more organic materials is deposited to form one or more organic layers of an organic stack 416. The organic stack 416 is on the first electrode 411. The organic stack 416 includes a hole injection (conducting polymer) layer ("HIL") 417 and light emitting polymer (LEP) layer 420. If the first electrode 411 is an anode, then the HIL 417 is on the first electrode 411. Alternatively, if the first electrode 411 is a cathode, then the active electronic layer 420 is on the first electrode 411, and the HIL 417 is on the LEP layer 420. The electronic device 405 also includes a second electrode 423 on the organic stack 416. Other layers than that shown in FIG. 4 may also be added including barrier, charge transport, and interface layers between the first electrode 411 and the organic stack 416, and/or between the organic stack 416 and the second electrode 423 and/or between LEP layer 420 and HIL 417). Some of these layers, in accordance with the invention, are described in greater detail below. The "thickness" of a given layer is the distance or extension of that layer in a vertical direction of the shown cross-section as measured between the bottom of the layer immediately above the given layer and the top of the layer immediately below the given layer.

### Substrate 408:

The substrate 408 can be any material that can support the organic and metallic layers on it. The substrate 408 can be transparent or opaque (e.g., the opaque substrate is used in top-emitting devices). By modifying or filtering the wavelength of light which can pass through the substrate 408, the color of light emitted by the device can be changed. The substrate 408 can be comprised of glass, quartz, silicon, plastic, or stainless steel; preferably, the substrate 408 is comprised of thin, flexible glass. The preferred thickness of the substrate 408 depends on the material used and on the application of the device. The substrate 408 can be in the form of a sheet or continuous film. The continuous film can be used, for example, for roll-to-roll manufacturing processes which are particularly suited for plastic, metal, and metallized plastic foils. The substrate can also have transistors or other switching elements built in to control the operation of the device. A single substrate 408 is typically used to construct a larger OLED display containing many pixels (devices) such as device 405 arranged in some pattern.

### First Electrode 411:

In one configuration, the first electrode 411 functions as an anode (the anode is a conductive layer which serves as a hole-injecting layer and which comprises a material with work function greater than about 4.5 eV). Typical anode materials include metals (such as platinum, gold, palladium, indium, and the like); metal oxides (such as lead oxide, tin oxide, ITO (Indium Tin Oxide), and the like); graphite; doped inorganic semiconductors (such as silicon, germanium, gallium arsenide, and the like); and doped conducting polymers (such as polyaniline, polypyrrole, polythiophene, and the like).

The first electrode 411 can be transparent, semi-transparent, or opaque to the wavelength of light generated within the device. The thickness of the first electrode 411 is from about 10 nm to about 1000 nm, preferably, from about 50 nm to about 200 nm, and more preferably, is about 100 nm. The first electrode layer 411 can typically be fabricated using any of the techniques known in the art for deposition of thin films, including, for example, vacuum evaporation, sputtering, electron beam deposition, or chemical vapor deposition.

In an alternative configuration, the first electrode layer 411 functions as a cathode (the cathode is a conductive layer which serves as an electron-injecting layer and which comprises a material with a low work function). The cathode, rather than the anode, is deposited on the substrate 408 in the case of, for example, a top-emitting OLED. Typical cathode materials are listed below in the section for the "second electrode 423". In the configuration used in obtaining the experimental results shown in FIGs 1(a)-(b), 2 and 3, the first electrode 411 was an anode comprised of ITO.

### HIL 417:

The HIL 417, sometimes also addressed as hole transport layer (HTL), has a much higher hole mobility than electron mobility and is used to effectively transport holes from the first electrode 411 to the substantially uniform organic polymer layer 420. The HIL 417 is made of polymers or small molecule materials. For example, the HIL 417 can be made of tertiary amine or carbazole derivatives both in their small molecule or their polymer form, conducting polyaniline ("PANI"), or PEDOT:PSS (a solution of polyethylenedioxythiophene ("PEDOT") and polystyrenesulfonic acid ("PSS") available as Baytron P from HC Starck). The HIL 417 has a thickness from about 5nm to about 1000 nm, preferably from about 20 nm to about 500 nm, and more preferably from about 50 to about 250 nm.

The HIL 417 can be formed using selective deposition techniques or nonselective deposition techniques. Examples of selective deposition techniques include, for example, ink jet printing, flex printing, and screen printing. Examples of nonselective deposition techniques include, for example, spin coating, dip coating, web coating, and spray coating. The hole injection material is deposited on the first electrode 411 and then allowed to dry into a film. The dried material represents the hole transport layer. In the configuration used in obtaining the experimental results shown in FIG. 1(a)-(b), 2 and 3, the HIL 417 was PEDOT:PSS solution (such as that available from HC Starck) which was dried into a film of 200 nanometers.

### LEP Layer 420:

For organic LEDs (OLEDs), the LEP layer 420 contains at least one organic material that emits light. These organic light emitting materials generally fall into two categories. The first category of OLEDs, referred to as polymeric light emitting diodes, or PLEDs, utilize polymers as part of LEP layer 420. The polymers may be organic or organometallic in nature. As used herein, the term organic also includes organometallic materials. Preferably, these polymers are solvated in an organic solvent, such as toluene or xylene, and spun (spin-coated) onto the device, although other deposition methods are possible. Devices utilizing polymeric active electronic materials in LEP layer 420 are especially preferred. Optionally, LEP layer 420 may include a light responsive material that changes its electrical properties in response to the absorption of light. Light responsive materials are often used in detectors and solar panels that convert light energy to electrical energy.

The light emitting organic polymers in the LEP layer 420 can be, for example, EL polymers having a conjugated repeating unit, in particular EL polymers in which neighboring repeating units are bonded in a conjugated manner, such as polythiophenes, polyphenylenes, polythiophenevinylenes, or poly-p-phenylenevinylenes or their families, copolymers, derivatives, or mixtures thereof. More specifically, the organic polymers can be, for example: polyfluorenes; poly-p-phenylenevinylenes that emit white, red, blue, yellow, or green light and are 2-, or 2, 5- substituted poly-p-pheneylenevinylenes; polyspiro polymers; or their families, copolymers, derivatives, or mixtures thereof.

If the organic electronic device 405 is an organic solar cell or an organic light detector, then the organic polymers are light responsive material that changes its electrical properties in response to the absorption of light. The light responsive material converts light energy to electrical energy.

If the organic electronic device 405, is an organic transistor, then the organic polymers can be, for example, polymeric and/or oligomeric semiconductors. The polymeric semiconductor can comprise, for example, polythiophene, poly(3-alkyl)thiophene, polythienylenevinylene, poly(paraphenylenevinylene), or polyfluorenes or their families, copolymers, derivatives, or mixtures thereof.

In addition to polymers, smaller organic molecules that emit by fluorescence or by phosphorescence can serve as a light emitting material residing in LEP layer 420. Unlike polymeric materials that are applied as solutions or suspensions, small-molecule light emitting materials are preferably deposited through evaporative, sublimation, or organic vapor phase deposition methods. Combinations of PLED materials and smaller organic molecules can also serve as active electronic layer. For example, a PLED may be chemically derivatized with a small organic molecule or simply mixed with a small organic molecule to form LEP layer 420.

In addition to active electronic materials that emit light, LEP layer 420 can include a material capable of charge transport. Charge transport materials include polymers or small molecules that can transport charge carriers. For example, organic materials such as polythiophene, derivatized polythiophene, oligomeric polythiophene, derivatized oligomeric polythiophene, pentacene, compositions including C60, and compositions including derivatized C60 may be used. LEP layer 420 may also include semiconductors, such as silicon or gallium arsenide.

In accordance with at least one embodiment of the invention, the LEP layer 420 has a thickness of greater than 80 nm and preferably, between 80 and 200 nm. "Thickness of the LEP layer" as used in describing this and other embodiments of the invention, refers to the distance between bottom of the second electrode 423 and the top of the HIL 417 in a vertical direction. The thicker LEP layer 420 has been show to increase the photopic efficiency and lifetime of device 420. In other embodiments of the invention, the combined thickness of the layers in the organic stack, i.e. LEP layer 420 and HIL 417, is held at a constant. For example, assume the combined thickness of the layers in the organic stack was fixed to be 275 nanometers. If the LEP layer 420 were 150 nanometers thick, then the HIL 417 would be 125 nanometers. Likewise, if the LEP layer 420 thickness were 165 nanometers, then the HIL 417 would be 110 nanometers.

All of the organic layers such as HIL 417 and LEP layer 420 can be ink-jet printed by depositing an organic solution or by spin-coating, or other deposition techniques. This organic solution may be any "fluid" or deformable mass capable of flowing under pressure and may include solutions, inks, pastes, emulsions, dispersions and so on. The liquid may also contain or be supplemented by further substances which affect the viscosity, contact angle, thickening, affinity, drying, dilution and so on of the deposited drops.

The LEP layer 420 is fabricated by depositing this solution, using either a selective or non-selective deposition technique, onto HIL 417. To obtain a thicker LEP layer 420, in accordance with the invention, more drops or a greater concentration of polymer solution or a slower rotational speed while spin coating is required to be deposited.

### Second Electrode (423)

In one embodiment, second electrode 423 functions as a cathode when an electric potential is applied across the first electrode 411 and second electrode 423. In this embodiment, when an electric potential is applied across the first electrode 411, which serves as the anode, and second electrode 423, which serves as the cathode, photons are released from active electronic layer 420 that pass through first electrode 411 and substrate 408.

While many materials, which can function as a cathode, are known to those of skill in the art, most preferably a composition that includes aluminum, indium, silver, gold, magnesium, calcium, and/or barium, or combinations thereof, or alloys thereof, is utilized. Aluminum, aluminum alloys, and combinations of magnesium and silver or their alloys can also be utilized.

Preferably, the thickness of second electrode 423 is from about 10 to about 1000 nanometers (nm), more preferably from about 50 to about 500 nm, and most preferably from about 100 to about 300 nm. While many methods are known to those of ordinary skill in the art by which the first electrode material may be deposited, vacuum deposition methods, such as physical vapor deposition (PVD) are preferred. Other layers (not shown) such as a barrier layer and getter layer may also be used to protect the electronic device. Such layers are well-known in the art and are not specifically discussed herein.

Often other steps such as washing and neutralization of films, the addition of masks and photo-resists may precede the cathode deposition. However, these are not specifically enumerated as they do not relate specifically to the novel aspects of the invention. Other steps (not shown) like adding metal lines to connect the anode lines to power sources may also be included in the workflow. Also, for instance, after the OLED is fabricated it is often encapsulated to protect the layers from environmental damage or exposure. Such other processing steps are well-known in the art and are not a subject of the invention.

In other embodiments of the invention, a thick LEP layer enables the fabrication of electro-chemical OLEDS (EC-OLEDS). An electrochemically stable, dissociable salt, such as lithium triflate, tetrabutyl ammonium tetrafluoroborate, or the salts used in lithium batteries, thin film batteries or electrochromic devices can be added into the LEP layer. Under bias, holes are injected into the LEP layer, causing the LEP to be oxidized, while negatively charged ions from the salt can now diffuse to stabilize the positively charged LEP. Thus, a thin layer of the LEP thick film becomes p-doped and able to efficiently transport holes into the undoped LEP region. Simultaneously at the other electrode, electrons are injected into the LEP layer, causing the LEP to be reduced, while positively charged ions from the salt diffuse to stabilize the negatively charged LEP. Thus, a thin layer of the LEP thick film becomes n-doped and able to efficiently transport electrons into the undoped LEP region. These p-doped and n-doped layers created in-situ act as HIL and ETL, while the middle region is the LEP layer where recombination and light emission takes place. Non-reactive metal electrodes whose work functions are not critical for the operation of the device can be used in this type of devices.

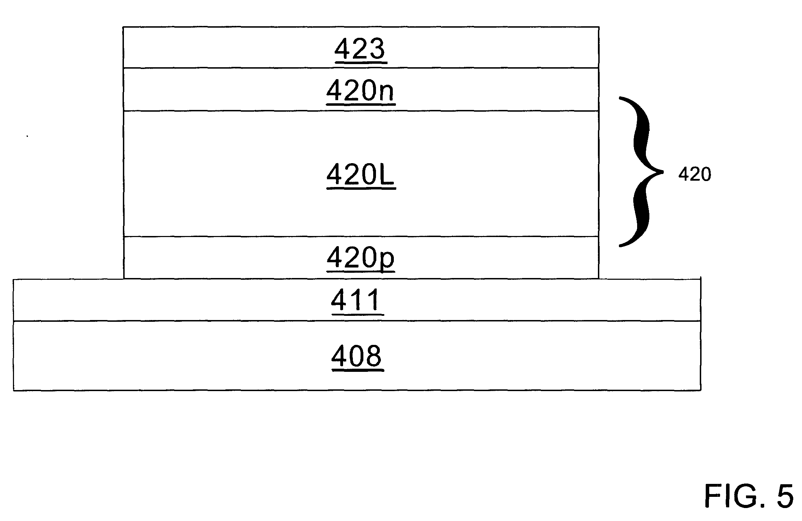

An EC-OLED stack is illustrated in FIG. 5. Electrodes 411 and 423 are non-reactive metal electrodes, for instance. Elements numbered in FIG. 5 like their counterparts in FIG. 4 may be as described above with respect to FIG. 4, except for the following modifications. As discussed, LEP layer 420 is segregated into three regions: an LEP region 420L and a p-doped layer 420p and an n-doped layer 420n. This segregation occurs starting with a thicker than conventional LEP layer 420, having, for example a thickness of 80 nanometers or more, preferably a thickness between 80 and 200 nanometers where the boundaries are included, and adding a dissociable salt (for example) into the LEP layer 420. Assuming that the first electrode 411 is an anode and second electrode 423 is a cathode, the following occurs under application of a bias across these electrodes 411 and 423. Holes are injected into the LEP layer 420 at the interface of LEP layer 420 and first electrode 411 while electrons are injected into the LEP layer 420 at the interface with second electrode 423. This will cause oppositely charged ions to diffuse away those interfaces. Thus, negatively charged ions will diffuse away from the interface at first electrode 411 (due to the presence of holes) and create region 420p which is dominated by holes as the majority charge carrier. Likewise, positively charged ions will diffuse away from the interface at second electrode 423 (due to the presence of electrons) and create region 420n which is dominated by electrons as the majority charge carrier. The region 420L will remain as a LEP region, while 420p would act as an HIL layer and 420n would act as an ETL (electron transport layer). In at least one embodiment, p-doped region 420p and/or n-doped region 420n may exist in LEP layer 420, even when no bias is applied. This can eliminate the need for a separate HIL layer 417 as shown in FIG. 4.

In yet other embodiments of the invention, a thick LEP layer can also be utilized in fabricating active matrix OLED displays. This is based upon testing done on passive matrix OLED displays under DC conditions, rather than on a multiplexed basis. It is expected that the DC results translates to a reasonable likelihood of similar performance in an active matrix setting where each OLED pixel is individually controlled by its own switching mechanism. Operating at lower voltages, active matrix displays can use thick LEP layers between 80 nm and 150 nm, approximately, but probably not much higher, unless a way can be found to support the higher voltages required to drive the LEP. Since active-matrix displays themselves operate at lower voltages than passive matrix displays, and since the power consumption of switching effects are less, overall power consumption is less a factor than with passive matrix displays.

While the embodiments of a thicker LEP layer are illustrated in which it is incorporated within an OLED device, this concept may be applied to other electronic devices that use an active electronic layer. For example, with a solar cell, the light responsive layer (i.e., the active electronic layer) can be comprised of a thick film polymer. The OLED device described earlier can be used in applications such as, for example, area, general, industrial and medical lighting, back lighting, computer displays, information displays in vehicles, television monitors, telephones, printers, and illuminated signs.

As any person of ordinary skill in the art of electronic device fabrication will recognize from the description, figures, and examples that modifications and changes can be made to the embodiments of the invention without departing from the scope of the invention defined by the following claims.

## Claims

1. An organic light emitting diode ("OLED") device having a plurality of stacked layers, comprising:
a light emitting polymer layer having a thickness, as measured between two layers adjacent thereto of eighty nanometers or more.

2. A device according to claim 1, wherein the light emitting polymer layer has a thickness, as measured between two layers adjacent thereto of between eighty and two hundred nanometers.

3. A device according to claim 1 or 2 further comprising:
a cathode layer, said cathode layer adjacent to said light emitting polymer layer; and
a hole injection layer, said hole injection layer also adjacent to said light emitting polymer layer, said thickness measured between said cathode layer and said hole injection layer.

4. A device according to claim 3 wherein the combined thickness of the light emitting polymer layer and hole injection layer is held fixed, the thickness of the hole injection layer decreasing with an increase in the thickness of the light emitting polymer layer.

5. A device according to one of claims 1 to 4 further comprising:
an anode layer.

6. A device according to one of the preceding claims wherein said hole injection layer and/or said light emitting polymer layer are formed using at least one organic material.

7. A device according to one of the preceding claims wherein said light emitting polymer layer is formed using at least one of a selective deposition technique and a non-selective deposition technique.

8. A device according to claim 7 wherein said selective deposition technique includes inkjet printing.

9. A device according to claim 7 or 8 wherein said non-selective deposition technique includes spin coating.

10. A device according to one of the preceding claims wherein said device is used to create an OLED display.

11. A device according to claim 10 wherein said OLED display is passive matrix in nature.

12. A device according to claim 10 or 11 wherein said OLED display is active matrix in nature.

13. An organic light emitting diode ("OLED") device, comprising:
a substrate;
a first electrode on said substrate;
a light emitting polymer layer, said light emitting polymer layer having a p-doped region, an n-doped region and a light emitting region; and
a second electrode on said light emitting polymer layer.

14. The OLED device of claim 13 wherein said p-doped region acts as a hole injection layer.

15. The OLED device of claim 13 or 14 wherein said n-doped region acts as an electron injection layer.

16. The OLED device according to one of claims 13 to 15 wherein said light emitting polymer layer includes a dissociable salt.

17. The OLED device according to claim 16 wherein a bias applied to said light emitting polymer creates said n-doped region and said p-doped region by mobilizing ions in said dissociable salt.
